# EUROPEAN PATENT APPLICATION

(11) **EP 4 365 966 A1**
(43) Date of publication of application: **08.05.2024**
(21) Application number: 23802428.5
(22) Date of filing: 31.01.2023
(51) Int. Cl.: H01L 31/18, H01L 31/068

(54) **BIFACIAL SOLAR CELL AND PREPARATION METHOD THEREFOR**

(30) Priority: 11.05.2022 CN 202210514798
(71) Applicant: Tongwei Solar (Meishan) Co., Ltd., Meishan, Sichuan 620041 (CN)
(72) Inventor: CHEN, Hao, Meishan, Sichuan 620041 (CN); WANG, Xiupeng, Meishan, Sichuan 620041 (CN); XING, Guoqiang, Meishan, Sichuan 620041 (CN)
(74) Representative: Marks & Clerk LLP
(86) International application number: PCT/CN2023/073917
(87) International publication number: WO 2023/216652

(57) **Abstract**

The present application provides a bifacial solar cell and a preparation method of the bifacial solar cell, and relates to the field of photovoltaics. The preparation method of the present application utilizes a method of deposition and then bombardment to form an intrinsic silicon layer, thus enhancing an ablation resistance of a solar cell, reducing a metal composite loss and a filing coefficient, and significantly improving an efficiency of an obtained solar cell. Moreover, in the bifacial solar cell of the present application, compared with a second crystalline silicon doped layer, the intrinsic silicon layer has a higher number of -SiH connected to mono-hydrogen atoms, a lower number of SiH₂ connected to dihydrogen atoms, and fewer carrier recombination defects in the intrinsic silicon layer, thus improving field passivation performance.

## Description

### CROSS-REFERENCE TO RELATED APPLICATIONS

This application claims priority to Chinese Patent Application No. 202210514798.6, filed on May 11, 2022 with China National Intellectual Property Administration, entitled "BIFACIAL SOLAR CELL AND PREPARATION METHOD THEREFOR", the content of which is hereby incorporated by reference in its entirety.

### TECHNICAL FIELD

The present application relates to the technical field of photovoltaic, and in particular, to a bifacial solar cell and a preparation method therefor.

### BACKGROUND

At present, a crystalline silicon doping layer in a solar cell has a greater influence on efficiency of the solar cell. Because the crystalline silicon doping layer includes a quantity of doping ions such as phosphorus and boron, an electric field can be formed inside the solar cell, and acts on a carrier, thereby providing field passivation and interface passivation for the solar cell, and improving an open circuit voltage of the battery. In addition, in a subsequent process of printing and sintering, the crystalline silicon doping layer can reduce a risk of being ablated by a metal silver paste to a certain extent, thereby improving a contact resistance and a metal composite current of the solar cell.

However, a crystalline silicon doping layer of the solar cell in a related art has a limited passivation effect on the solar cell and a relatively limited ablation resistance. That is, there is an improving possibility for the performance of the solar cell.

### SUMMARY

The present application provides a bifacial solar cell and a preparation method therefor, which can at least improve a passivation effect, an ablation resistance and a conversion efficiency of the bifacial solar cell.

Some embodiments of the present application provide a method for preparing a bifacial solar cell, which include the following steps: providing a silicon wafer with a silicon oxide doped layer disposed on one side and a first crystalline silicon doped layer disposed on one side and depositing an intrinsic silicon film on a surface of the silicon oxide doped layer using a silicon source as a raw material; bombarding the intrinsic silicon film by a plasma gas, and repeating a process of depositing the intrinsic silicon film and a process of bombarding the intrinsic silicon film by the plasma gas for 0 to 50 times to form an intrinsic silicon layer, wherein repeating for 0 times is that the method includes one process of depositing the intrinsic silicon film and one process of bombarding the intrinsic silicon film with the plasma gas; and depositing a second crystalline silicon doped layer on a surface of the intrinsic silicon layer by using a silicon source and a second doping source as a raw material, wherein the silicon wafer is N-type, the second crystalline silicon doped layer is N-type, and the first crystalline silicon doped layer is P-type; or, the silicon wafer is P-type, the second crystalline silicon doped layer is P-type, and the first crystalline silicon doped layer is N-type.

In the above embodiments, by bombarding the intrinsic silicon film with the plasma gas, it can change a microstructure of the intrinsic silicon film, reduce internal holes and make structure denser, thus forming the intrinsic silicon layer with greater physical strength. The obtained intrinsic silicon layer is not easy to crack in a subsequent high temperature process, and it is also enhance an ablation resistance of the bifacial solar cells. In addition, the intrinsic silicon layer formed after a process of bombarding the intrinsic silicon film can reduce a parasitic absorption of light on a back side of the bifacial solar cells and improve a current. Moreover, -SiH₂ in the intrinsic silicon film will be converted into -SiH during the process of bombarding, but an overall number of hydrogen atoms remains unchanged, resulting in fewer defects of carrier recombination in the intrinsic silicon layer and improving the field passivation performance.

If the intrinsic silicon layer with a less thickness is required, the intrinsic silicon film with a thin thickness is deposited at one time, and then the intrinsic silicon layer is obtained by bombarding the intrinsic silicon film. If the intrinsic silicon film with a greater thickness is required, a process of depositing the intrinsic silicon film and a process of bombarding the intrinsic silicon film are respectively repeated multi times and then the intrinsic silicon layer with a greater thickness is obtained, the obtained intrinsic silicon layer has greater physical strength and fewer defects of carrier recombination.

When the silicon wafer is N-type, the second crystalline silicon doped layer is N-type, and the first crystalline silicon doped layer is P-type, the bifacial solar cell belongs to an N-type TOPCon (Tunnel Oxide Passivated Contact) solar cell. The solar cells have extreme high conversion efficiency, which is adjacent to a theoretical conversion efficiency of crystalline silicon solar cells. In the TOPCon solar cells, the N-type doping layer contains a certain concentration of phosphorus ions, which can form an electric field inside the solar cell and act on carriers, providing field passivation and interface passivation for the solar cell and improving the open circuit voltage of the solar cell. When the silicon wafer is P-type, the second crystalline silicon doped layer is P-type, and the first crystalline silicon doped layer is N-type, the bifacial solar cell belongs to a P-type solar cell.

In an embodiment, in a process of bombarding the intrinsic silicon film by the plasma gas, a bombardment time is in a range of 0.1 s to 600 s; and/or, the plasma gas is at least one of an argon gas, a nitrogen gas or a hydrogen gas.

In this way, the bombardment time can be controlled in the range of 0.1 s and 600s, which can make the obtained intrinsic silicon layer more compact.

In an embodiment, after depositing the second crystalline silicon doped layer, the method further includes a step of an annealing treatment. An annealing temperature is in a range of 600 °C to 1000 °Cand an annealing time is in a range of 5 min to 35 min.

In this way, by the annealing treatment, it can further improve a conversion efficiency of the bifacial solar cells.

In an embodiment, the preparation method further includes a step of depositing an anti-reflection layer on a surface of the second crystalline silicon doped layer using a silicon nitride as a raw material.

In this way, the anti-reflection layer deposited on a surface of the second crystalline silicon doped layer can improve a light absorption efficiency of the bifacial solar cells, such that improving a conversion efficiency of the bifacial solar cells.

In an embodiment, the first crystalline silicon doped layer disposed on one side of the silicon wafer is prepared by following steps: using a first doping source and a silicon source as raw materials, and forming the first crystalline silicon doped layer by diffusing and depositing the first doping source and the silicon source on one side of the silicon wafer, optionally, the first doping source includes a boron source; and/or, the silicon oxide doped layer disposed on one side of the silicon wafer is prepared by following steps: using an oxidizing agent and a silicon source as raw materials, depositing the silicon oxide doped layer on one side of the silicon wafer, optionally, the oxidizing agent includes at least one of a nitrous oxide gas, an oxygen gas, or an ozone gas.

In this way, the first doping source can be boron source, which can ensure that the formed first crystalline silicon doped layer is a P-type doping layer, thus obtaining a TOPCon solar cell.

In an embodiment, the method further includes a step of depositing an anti-reflection layer on a surface of the first crystalline silicon doped layer using a silicon nitride as a raw material.

In this way, the anti-reflection layer deposited on a surface of the first crystalline silicon doped layer can improve a light absorption efficiency of the bifacial solar cells, such improving the conversion efficiency of the bifacial solar cells.

In an embodiment, after depositing the anti-reflection layer, the method further includes a step of screen printing a gate line on a surface of the anti-reflection layer and sintering to form a positive electrode and a negative electrode respectively, wherein a sintered temperature is 830 °C.

In an embodiment, the second doping source is a phosphorus source, and optionally, the phosphorus source can be at least one of a phosphane, a phosphorus oxychloride, or a phosphoryl bromide; and/or, the silicon source is silane.

In this way, the second doping source is a phosphorus source, which can ensure that the formed first crystalline silicon doped layer is a N-type doping layer, thus obtaining a TOPCon solar cell.

In other embodiments of the present application provide a bifacial solar cell, which can be prepared by any one of the above methods. The bilateral solar cell includes a first crystalline silicon doped layer, a silicon wafer, a silicon oxide doped layer, an intrinsic silicon layer, and a second crystalline silicon doped layer stacked in order.

In the embodiments, another layer of the intrinsic silicon layer is disposed between the silicon oxide doped layer and the second crystalline silicon doped layer, which can enhance an ablation resistance of the bifacial solar cell and reduce a metal recombination loss and a filling coefficient. Moreover, compared with the second crystalline silicon doped layer, the intrinsic silicon layer has a higher number of -SiH connected to mono-hydrogen atoms and a lower number of -SiH₂ connected to dihydrogen atoms, and fewer carrier recombination defects in the intrinsic silicon layer, thus improving field passivation performance.

In an embodiment, a thickness of the intrinsic silicon layer is less than or equal to 200 nm.

In this way, the thickness of the intrinsic silicon layer is not greater than 200 nm, which can not only enhance an ablation resistance of the bifacial solar cell, reduce a metal recombination loss and a filling coefficient, but also limit a parasitic absorption loss of light on a back side of the bifacial solar cell without affecting a conversion efficiency of the bifacial solar cell.

In an embodiment, an anti-reflection layer is further disposed on a surface of the second crystalline silicon doped layer away the intrinsic silicon layer, a surface of the first crystalline silicon doped layer away from the silicon wafer is provided a passivation layer and another anti-reflection layer stacked in order and the passivation layer is adjacent to the first crystalline silicon doped layer.

In the above technical scheme, the passivation layer can reduce a surface carrier recombination speed of the bifacial solar cell, and the anti-reflection layer can improve a light absorption efficiency of the bifacial solar cell, such that both improving a conversion efficiency of the bifacial solar cell.

### BRIEF DESCRIPTION OF THE DRAWINGS

In order to more clearly illustrate the technical solutions of the embodiments of the present application, the accompanying drawings that need to be used in the embodiments are briefly described below, and it should be understood that the following drawings illustrate only certain embodiments of the present application, and therefore should not be considered as limiting the scope of the present application.

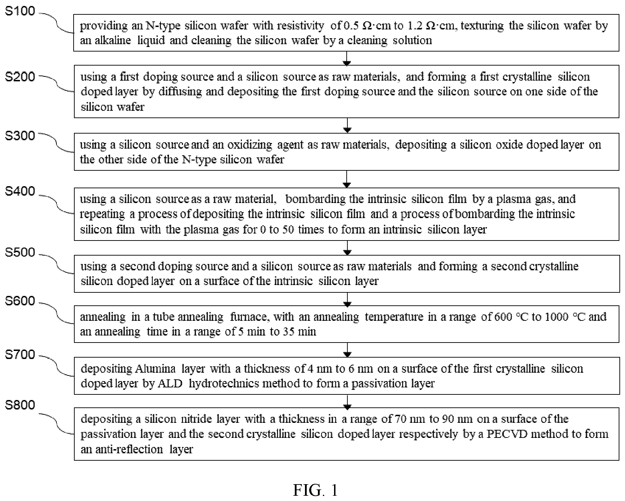

FIG. 1 is a process flowchart of a method for preparing an N-type TOPCon solar cell according to an embodiment of the present application.

### DETAILED DESCRIPTION

To make the objectives, technical solutions, and advantages of the embodiments of the present application clearer, the following clearly and completely describes the technical solutions in the embodiments of the present application. If a specific condition is not specified in the embodiment, the condition is performed according to the conventional condition or the condition recommended by the manufacturer. If the reagent or instrument used is not specified by the manufacturer, it is a regular product available for commercial purchase. The terms "first", "second", and the like are used only to distinguish descriptions, and are not understood to indicate or imply relative importance.

A bifacial solar cell and a preparation method thereof are specifically described below in the embodiments of the present application.

FIG. 1 is a process flowchart of a method for preparing an N-type TOPCon solar cell according to an embodiment of the present application. The method includes following steps.

S100, texturing is performed, including providing an N-type silicon wafer with resistivity of 0.5 Ω·cm to 1.2 Ω cm, texturing the silicon wafer by an alkaline liquid and cleaning the silicon wafer by a cleaning solution. A crystalline silicon doping layer and the silicon wafer are both formed by doping crystalline silicon with elements such as a phosphorus or a boron, and the difference is that a thickness of the silicon wafer is much greater than that of the crystalline silicon doping layer. When the silicon wafer is doped with the phosphorus, the doped silicon wafer or the crystalline silicon doping layer is N-type. When the silicon wafer is doped with the boron, the doped silicon wafer or the crystalline silicon doping layer is P-type. In the N-type TOPCon solar cell of the present application, the silicon wafer is an N-type silicon wafer, and a thickness of the silicon wafer is 160 µm to 170 µm. In some other embodiments, when a P-type bifacial solar cell is required, N-type silicon wafer can be replaced by a P-type silicon wafer.

In detail, the cleaning solution in step S100 can be an alkaline solution containing KOH with a concentration of 1% by mass, and the cleaning solution is at least one of hydrogen peroxide or alkaline solution.

S200, a first crystalline silicon doped layer is formed, including using a first doping source and a silicon source as raw materials, and forming the first crystalline silicon doped layer by diffusing and depositing the first doping source and the silicon source on one side of the silicon wafer. A thickness of the first crystalline silicon doped layer is in a range of 0.8 µm to 1.2 µm. A P-N junction is formed by the first crystalline silicon doped layer and the N-type silicon wafer.

In this embodiment of the present application, to obtain the N-type TOPCon solar cell, boron is doped in the first crystalline silicon doped layer, and a P-type doping layer is formed. The first doping source is a boron source, such as a borane, a boron trichloride or a boron tribromide. A temperature of diffusing and depositing is in a range of 900 °C to 1100 °C. In addition, the silicon source in the embodiment of the present application is generally silane, and the silicon source in subsequent steps is also silane.

In this embodiment, the first doping source is BCl₃, and a temperature of a process of diffusing and depositing the first doping source and the silicon source on one side of the silicon wafer is 1000 °C.

In this embodiment of the present application, if the P-type bifacial solar cell is required to be prepared, the first doping source in this step needs to be changed to a phosphorus source, which is not repeated here.

After the first crystalline silicon doped layer is formed, it is usually etched and alkali pickled. A process of alkali pickling includes: removing wraparound BSG formed in the boron diffusion from the back side and the side surface of the silicon wafer using a chain HF machine, and then using a robot to transfer the silicon wafer to a slot alkali throwing machine to remove P-N junctions on the back side and edge of the silicon wafer, to obtain the silicon wafer with an alkali polishing morphology.

S300, a silicon oxide doped layer is formed including using a silicon source and an oxidizing agent as raw materials, a silicon oxide doped layer is deposited on the other side of the N-type silicon wafer.

In this step S300, the silicon oxide doped layer is generally prepared by PECVD (plasma enhanced chemical vapor deposition), which can accurately control a thickness of the silicon oxide doped layer in a range of 0.1 nm to 2 nm. The oxidizing agent includes at least one of a nitrous oxide gas, an oxygen gas, or an ozone gas. In this embodiment, the oxidizing agent is the nitrous oxide gas.

S400, an intrinsic silicon film on a surface of the silicon oxide doped layer is deposited using a silicon source as a raw material, the intrinsic silicon film is bombarded by a plasma gas, and a process of depositing the intrinsic silicon film and a process of bombarding the intrinsic silicon film with the plasma gas are repeated for 0 to 50 times to form an intrinsic silicon layer.

In this step S400, a process of bombarding the intrinsic silicon film by a plasma gas can change a microstructure of the intrinsic silicon film, resulting in fewer holes in the intrinsic silicon layer, denser structure and greater physical strength of the intrinsic silicon layer. The above effect is especially obvious when a thickness of the intrinsic silicon layer is less than 20 nm, which can ensure that the thin intrinsic silicon layer has enough strength and is not easy to crack in a subsequent process at high temperature. Similarly, in the subsequent sintering process, the intrinsic silicon layer with greater physical strength can also effectively enhance an ablation resistance of solar cells and reduce the loss of metal recombination and a filling coefficient. In addition, the intrinsic silicon layer with more compact structure can reduce a parasitic absorption of light on a back side of the bilateral solar cell and improve a short-circuit current of the bilateral solar cell. In this step S400, the plasma gas includes at least one of an argon gas, a nitrogen gas and a hydrogen gas, a bombardment time is in a range of 0.1 s to 600 s, for example, the bombardment time can be 0.1 s, 1 s, 10 s, 12 s, 20 s, 40 s, 80 s, 150 s, 400 s, 500 s, 580 s or 600s. In this embodiment, the plasma gas is the argon gas, and the bombardment time is 12 s.

After the intrinsic silicon film is bombarded by the plasma gas to form the intrinsic silicon layer, -SiH₂ will be converted into -SiH in the bombarding process, which makes the number of -SiH connected by mono-hydrogen atoms in the intrinsic silicon layer be higher, the number of -SiH₂ connected by dihydrogen atoms be lower, and overall hydrogen atoms content remain unchanged, further makes fewer carrier recombination defects in the intrinsic silicon layer, thus improving field passivation performance.

Because a depth of the single bombardment of the plasma gas on the deposited intrinsic silicon film is limited, it is necessary to repeat a process of depositing the intrinsic silicon film and a process of bombarding the intrinsic silicon film with the plasma gas to obtain a thicker intrinsic silicon layer (with a thickness of not less than 5 nm) and ensure that the intrinsic silicon layer has greater physical strength and few defects. By one process of depositing the intrinsic silicon film and one process of bombarding the intrinsic silicon film by the plasma gas, a thin intrinsic silicon layer is obtained (that is, repeating for 0 times). When repeatedly depositing, a thickness of the intrinsic silicon film in each repeating can be same or different, and when repeatedly bombarding with the plasma gas, the bombarding time can be same or different. However, for a convenience of operation, in this embodiment, the thickness of the intrinsic silicon film obtained in each repeating process when repeatedly depositing and bombarding is the same, and the bombarding time in each repeating process is the same, which is 12 s.

In addition, in order to accurately control the thickness of the intrinsic silicon layer, the intrinsic silicon layer is generally prepared by PECVD in this step, and the preparation is carried out in an atmosphere of inert gas to protect the intrinsic silicon layer.

S500, a second crystalline silicon doped layer is formed, including using a second doping source and a silicon source as raw materials and forming a second crystalline silicon doped layer on a surface of the intrinsic silicon layer. The formed second crystalline silicon doped layer can provide field passivation and interface passivation for the bilateral solar cell, and can also be used together with the intrinsic silicon layer to enhance an ablation resistance of the bilateral solar cell. A thickness of the second crystalline silicon doped layer is in a range of 80 nm to 120 nm.

In the embodiment of the present application, to obtain the N-type TOPCon solar cell, phosphorus is doped in the second crystalline silicon doped layer to form an N-type doping layer. The second doping source is a phosphorus source, and the phosphorus source can be at least one of phosphane, phosphorus oxychloride, and phosphoryl bromide. In this embodiment, the phosphorus source is phosphane. In some other embodiments, if a P-type bifacial solar cell needs to be prepared, the second doping source is required to be a boron source, and details are not described herein again.

Similarly, in order to accurately control the thickness, this step is generally to prepare the second crystalline silicon doped layer by PECVD method, and it is also carried out in an atmosphere of inert gas to protect the second crystalline silicon layer.

S600, an annealing treatment is performed. The bilateral solar cell is annealed in a tube annealing furnace. A temperature of the annealing treatment in a range of 600 °C to 1000 °C, and a time of the annealing treatment in a range of 5 min to 35 min. In this embodiment, a temperature of the annealing treatment is 900 °C, a time of the annealing treatment is 20 min, and a gas atmosphere during the annealing treatment is a nitrogen (N₂) gas.

After the annealing treatment, RCA cleaning is performed on the bifacial solar cell including using a chain HF machine to remove excess oxide layer in the bilateral solar cell and transferring to an alkali bath to remove wraparound crystalline silicon layer on the front side of the silicon wafer.

S700, a passivation layer is formed. Alumina (AlOₓ) layer with a thickness of 4 nm to 6 nm is deposited on a surface of the first crystalline silicon doped layer by ALD (Atomic layer deposition) hydrotechnics method, which is used as a passivation layer.

The passivation layer can reduce a recombination speed of surface carrier of the bilateral solar cell and improve an energy conversion efficiency of the bilateral solar cell. The thickness of the passivation layer is generally in a range of 4 nm to 6 nm, for example, 4 nm, 5 nm or 6 nm. In other embodiments, the passivation layer can also be omitted.

S800, an anti-reflection layer is formed. A silicon nitride layer with a thickness in a range of 70 nm to 90 nm is deposited on a surface of the passivation layer and the second crystalline silicon doped layer respectively by a PECVD method, and the silicon nitride layer is used as an anti-reflection layer.

The anti-reflection layer can reduce a light reflectivity of solar cells, and increase a light absorption efficiency of solar cells, and improve an energy conversion efficiency of solar cells. For example, a thickness of the anti-reflection layer in this embodiment is same, both of which are in a range of 70 nm to 90 nm, such as 70 nm, 75 nm, 80 nm, 85 nm or 90 nm. In other embodiments, the passivation layer can also be omitted.

In some other embodiments, after forming the anti-reflection layer, the method further includes screen printing a gate line on a surface of the anti-reflection layer and sintering to form a positive electrode and a negative electrode respectively. A sintered temperature is 830 °C.

The N-type TOPCon solar cell obtained by using the above preparation method includes the anti-reflection layer, the second crystalline silicon doped layer (N-type), the intrinsic silicon layer, the silicon oxide doped layer, the silicon wafer (N-type), the first crystalline silicon doped layer (P-type), the passivation layer, and the anti-reflection layer stacked in order.

In this embodiment of the present application, when the bilateral solar cell works, the carrier is generated from a contact surface between the P-type first crystalline silicon doped layer and the N-type silicon wafer, and then flows to upper and lower surfaces of the N-type TOPCon solar cell to generate a voltage. If the N-type TOPCon solar cell is electrically connected to external objects by a wire, the N-type TOPCon solar cell can output a current to the external objects. The intrinsic silicon layer and the N-type second crystalline silicon doped layer can enhance an ablation resistance of the bilateral solar cell and reduce a metal recombination loss and a filling coefficient. Moreover, compared with the second crystalline silicon doped layer, the intrinsic silicon layer has a higher number of -SiH connected by mono-hydrogen atoms and a lower number of -SiH₂ connected by dihydrogen atoms, and there are fewer defects of carrier recombination in the intrinsic silicon layer, thus improving field passivation performance. At the same time, in this embodiment of the present application, the thickness of the intrinsic silicon layer in the bilateral solar cell is generally not more than 200 nm, so that a parasitic absorption loss of light on a back side of the bilateral solar cell can be limited, and a carrier transmission will not be obviously hindered. In addition, the types of the silicon wafer and the crystalline silicon doping layer in the bilateral solar cell can also be adjusted as follows: the P-type silicon wafer, the N-type first crystalline silicon doped layer, the P-type second crystalline silicon doped layer, at this time, the bilateral solar cell is no longer a N-type TOPCon solar cell, details are not described herein again.

The features and performance of the present application are further described in detail below with reference to the examples.

### Example 1

This example of the present application provides an N-type TOPCon solar cell, a preparation method of the N-type TOPCon solar cell including following steps:
S100, texturing: providing an N-type silicon wafer with resistivity of 0.8 Ω·cm, texturing the silicon wafer by an alkaline liquid containing NaOH with a concentration of 1% by mass and cleaning the silicon wafer by a hydrogen peroxide and alkaline solution;
S200, forming a P-type doping layer, i.e. depositing a boron diffusion layer on the N-type silicon wafer, including introducing BCl₃, and forming the P-type doping layer by diffusing and depositing BCl₃ at one side of the N-type silicon wafer at 1000 °C;
S300, forming a silicon oxide doped layer: putting the silicon wafer obtained in step S200 into a tubular PECVD device, introducing silane and nitrous oxide into the tubular PECVD device, and preparing a silicon oxide doped layer with a thickness of 1nm by pulse discharge;
S400, forming an intrinsic silicon layer: introducing silane and an inert gas into the tubular PECVD device, and depositing an intrinsic silicon film with a thickness of 5 nm on a surface of the silicon oxide doped layer, and then bombarding the intrinsic silicon film with an argon plasma gas for 12 s, to make an intrinsic silicon layer with a thickness of 5 nm;
S500, forming a N-type doping layer: introducing phosphine, silane and an inert gas into the tubular PECVD device, and depositing and forming a second crystalline silicon doped layer with a thickness of 60 nm on a surface of the intrinsic silicon layer;
S600, annealing treatment: using a tube annealing furnace to perform the annealing treatment, an annealing gas atmosphere is nitrogen, wherein an annealing temperature is 900 °C, and an annealing time is 20 min; after the annealing, a RCA cleaning is performed on the silicon wafer;
S700, forming a passivation layer: using an ALD hydrotechnics method to deposit alumina with a thickness of 5 nm on a surface of the N-type doping layer as a passivation layer; and
S800, forming an anti-reflection layer: using a PECVD method to deposit silicon nitride with a thickness of 85 nm on a surface of the passivation layer as the anti-reflection layer, and then depositing silicon nitride with a thickness of 70 nm on a surface of the N-type doping layer as an anti-reflection layer.

The obained N-type TOPCon solar cell includes the intrinsic silicon layer with a thickness of 5 nm, and the intrinsic silicon layer is formed by one process of depositing the intrinsic silicon film and one process of bombarding the intrinsic silicon film by the plasma gas.

### Example 2

This example of the present application provides an N-type TOPCon solar cell. A method for preparing the N-type TOPCon solar cell in Example 2 is substantially the same as that of the method in Example 1, the difference is in that:
S400, forming an intrinsic silicon layer: introducing silane and an inert gas into the tubular PECVD device, and depositing an intrinsic silicon film with a thickness of 5 nm on a surface of the silicon oxide doped layer, then bombarding the intrinsic silicon film with an argon plasma gas for 12 s, and repeating a process of depositing an intrinsic silicon film and a process of bombarding the intrinsic silicon film with the argon plasma gas for three times, to make an intrinsic silicon layer with a thickness of 20nm, wherein the thickness of the intrinsic silicon film in each repeating process is 5 nm, and each bombarding time is 12 s.

The obtained N-type TOPCon solar cell includes the intrinsic silicon layer with a thickness of 20 nm, and the intrinsic silicon layer is formed by multi processes of depositing the intrinsic silicon film and multi processes of bombarding the intrinsic silicon film by the plasma gas.

### Example 3

This example of the present application provides an N-type TOPCon solar cell, A method for preparing the N-type TOPCon solar cell in Example 3 is substantially the same as that of the method in Example 1, the difference is in that:
S400, forming an intrinsic silicon layer: introducing silane and an inert gas into the tubular PECVD device, and depositing an intrinsic silicon film with a thickness of 20 nm on a surface of the silicon oxide doped layer, and then bombarding the intrinsic silicon film with an argon plasma gas for 12 s.

The obtained N-type TOPCon solar cell includes the intrinsic silicon layer with a thickness of 20 nm, and the intrinsic silicon layer is formed by one process of depositing the intrinsic silicon film and one process of bombarding the intrinsic silicon film by the plasma gas.

### Comparative Example 1

This comparative example provides an N-type TOPCon solar cell. A method for preparing the N-type TOPCon solar cell in comparative example 1 is substantially the same as that of the method in Example 1, the difference is in that: step S400 is not performed. The obtained N-type TOPCon solar cell in this comparative example does not include the intrinsic silicon layer.

### Comparative Example 2

This comparative example provides an N-type TOPCon solar cell. A method for preparing the N-type TOPCon solar cell in comparative example 2 is substantially the same as that of the method in Example 1, the difference is in that:
S400, forming an intrinsic silicon layer: introducing silane and an inert gas into the tubular PECVD device, and depositing an intrinsic silicon film with a thickness of 5 nm on a surface of the silicon oxide doped layer to form the intrinsic silicon layer. The obtained N-type TOPCon solar cell includes the intrinsic silicon layer with a thickness of 5 nm, and the intrinsic silicon layer is deposited by using the PECVD method without bombarding the intrinsic silicon film by the plasma gas.

### Comparative Example 3

This comparative example provides an N-type TOPCon solar cell. A method for preparing the N-type TOPCon solar cell in comparative example 3 is substantially the same as that of the method in Example 1, the difference is in that:
S400, forming an intrinsic silicon layer: introducing silane and an inert gas into the tubular PECVD device, and depositing an intrinsic silicon film with a thickness of 20 nm on a surface of the silicon oxide doped layer to form the intrinsic silicon layer.

The obtained N-type TOPCon solar cell includes the intrinsic silicon layer with a thickness of 20 nm, and the intrinsic silicon layer is deposited by using the PECVD method without bombarding the intrinsic silicon film by the plasma gas.

### Application Example

The performance of the N-type TOPCon solar cells in Examples 1 to 3 and Comparative Examples 1 to 3 is tested respectively. The electrical performance of the N-type TOPCon solar cells is tested by a Halm tester, and the number of film bursting points on a back side of the N-type TOPCon solar cells are tested by a scanning electron microscope (SEM). The results are as follows:

**Table 1: The performance of the N-type TOPCon solar cells in Examples 1 to 3 and Comparative Examples 1 to 3**

| Group | Open-circu it voltage (V) | Short circuit current (mA/cm²) | Filling factor | Conversion efficiency (%) | The number of film bursting points |
|---|---|---|---|---|---|
| | | | (%) | | (number/10µm²) |
| Examples 1 | 0.712 | 41.52 | 82.01 | 24.24 | 0-5 |
| Examples 2 | 0.715 | 41.51 | 81.98 | 24.33 | 0 |
| Examples 3 | 0.713 | 41.49 | 82.03 | 24.27 | 0 |
| Comparative Examples 1 | 0.703 | 41.36 | 81.82 | 23.85 | >100 |
| Comparative Examples 1 | 0.708 | 41.52 | 81.87 | 24.07 | >50 |
| Comparative Examples 1 | 0.710 | 41.47 | 82.03 | 24.15 | 20-40 |

As shown in test result of Example 1 and Comparative Example 1 of Table 1, it can be seen that conversion efficiency of the solar cells provided with the intrinsic silicon layer is greater, and the number of film bursting points is less, which shows that a physical strength of the solar cells is greater and it is less likely to be damaged. Especially in the high temperature process, the solar cells are less likely to be broken.

As shown in test result of Example 1 and Comparative Example 2 and test result of Example 3 and Comparative Example 3 of Table 1, it can be seen that when the intrinsic silicon layer is formed, the bombarding treatment by plasma gas on the deposited intrinsic silicon film can reduce the number of the film bursting points, increase the physical strength of the solar cells, and improve the conversion efficiency of the solar cells to a certain extent.

As shown in test result of Example 2 and Example 3 of Table 1, it can be seen that, by depositing and bombarding the intrinsic silicon film for many times, the obtained solar cells with a thicker intrinsic silicon layer can still have greater conversion efficiency.

The foregoing is merely an alternative example of the present application and is not intended to limit the present application, and for those skilled in the art, the present application may have various changes and changes. Any modification, equivalent replacement, improvement, etc. made within the spirit and principle of the present application shall fall within the protection scope of the present application.

### Industrial Applicability

The embodiments of the present application provide a bifacial solar cell and a preparation method of the bifacial solar cell. In the preparation method of the present application, the intrinsic silicon layer formed by depositing first and then bombarding can enhance an ablation resistance of the solar cells, reduce a metal recombination loss and a filling coefficient, and obviously improve conversion efficiency of the solar cells. Moreover, in the bifacial solar cell of the present application, compared with the second crystalline silicon doped layer, the intrinsic silicon layer has a higher number of -SiH connected to mono-hydrogen atoms, a lower number of SiH₂ connected to dihydrogen atoms, and fewer carrier recombination defects in the intrinsic silicon layer, thus improving field passivation performance.

In addition, it may be understood that the bifacial solar cell and the preparation method thereof in the present application can be reproduced, and can be used in multiple industrial applications. For example, the bifacial solar cell and the preparation method thereof in the present application can be used in the field of photovoltaic technologies.

## Claims

1. A method for preparing a bifacial solar cell, **characterized by** comprising following steps:
providing a silicon wafer with a silicon oxide doped layer disposed on one side and a first crystalline silicon doped layer disposed on one side, and depositing an intrinsic silicon film on a surface of the silicon oxide doped layer using a silicon source as a raw material;
bombarding the intrinsic silicon film by a plasma gas, and repeating a process of depositing the intrinsic silicon film and a process of bombarding the intrinsic silicon film with the plasma gas for 0 to 50 times to form an intrinsic silicon layer, wherein repeating for 0 times is that the method comprises one process of depositing the intrinsic silicon film and one process of bombarding the intrinsic silicon film by the plasma gas; and
depositing a second crystalline silicon doped layer on a surface of the intrinsic silicon layer by using a silicon source and a second doping source as a raw material,
wherein the silicon wafer is N-type, the second crystalline silicon doped layer is N-type, and the first crystalline silicon doped layer is P-type; or, the silicon wafer is P-type, the second crystalline silicon doped layer is P-type, and the first crystalline silicon doped layer is N-type.

2. The method of claim 1, wherein in a process of bombarding the intrinsic silicon film by the plasma gas, a bombardment time is in a range of 0.1 s to 600 s;
and/or, the plasma gas is at least one of an argon gas, a nitrogen gas or a hydrogen gas.

3. The method of claims 1 or 2, wherein after depositing the second crystalline silicon doped layer, the method further comprises a step of an annealing treatment, wherein an annealing temperature is in a range of 600 °C to 1000 °C and an annealing time is in a range of 5 min to 35 min.

4. The method of any one of claims 1 to 3, further comprising a step of depositing an anti-reflection layer on a surface of the second crystalline silicon doped layer using a silicon nitride as a raw material.

5. The method of any one of claims 1 to 3, wherein the first crystalline silicon doped layer disposed on one side of the silicon wafer is prepared by following steps: using a first doping source and a silicon source as raw materials, and forming the first crystalline silicon doped layer by diffusing and depositing the first doping source and the silicon source on one side of the silicon wafer, optionally, the first doping source comprises a boron source; and/or,
the silicon oxide doped layer disposed on one side of the silicon wafer is prepared by following steps: using an oxidizing agent and a silicon source as raw materials, depositing the silicon oxide doped layer on one side of the silicon wafer, optionally, the oxidizing agent comprises at least one of a nitrous oxide gas, an oxygen gas, or an ozone gas.

6. The method of claim 5, further comprising a step of depositing an anti-reflection layer on a surface of the first crystalline silicon doped layer using a silicon nitride as a raw material.

7. The method of claim 6, wherein after depositing the anti-reflection layer, the method further comprises a step of screen printing a gate line on a surface of the anti-reflection layer and sintering to form a positive electrode and a negative electrode respectively, wherein a sintered temperature is 830 °C.

8. The preparation method of any one of claims 1 to 7, wherein the second doping source is a phosphorus source, optionally, the phosphorus source is at least one of a phosphane, a phosphorus oxychloride, or a phosphoryl bromide; and/or, the silicon source is silane.

9. A bifacial solar cell prepared by the method of any one of claims 1 to 8, **characterized by** comprising: a first crystalline silicon doped layer, a silicon wafer, a silicon oxide doped layer, an intrinsic silicon layer, and a second crystalline silicon doped layer stacked in order.

10. The bifacial solar cell of claim 9, wherein a thickness of the intrinsic silicon layer is less than or equal to 200 nm.

11. The bifacial solar cell of claims 9 or 10, wherein an anti-reflection layer is further disposed on a surface of the second crystalline silicon doped layer away the intrinsic silicon layer, a surface of the first crystalline silicon doped layer away from the silicon wafer is provided a passivation layer and another anti-reflection layer stacked in order and the passivation layer is adjacent to the first crystalline silicon doped layer.
